# FASCICULE DE BREVET EUROPEEN

(11) **EP 2 345 097 B1**
(45) Date de publication et mention de la délivrance du brevet: **18.07.2018**
(21) Numéro de dépôt: 09741335.5
(22) Date de dépôt: 23.09.2009
(51) Int. Cl.: H01L 51/52, H01L 51/44

(54) **PROCEDE D'ENCAPSULATION D'UN DISPOSITIF OPTOELECTRONIQUE ORGANIQUE**
VERFAHREN ZUM EINKAPSELN EINER ORGANISCHEN OPTOELEKTRONISCHEN ANORDNUNG
METHOD FOR ENCAPSULATING AN ORGANIC OPTOELECTRONIC DEVICE

(30) Priorité: 30.09.2008 FR 0805381
(43) Date de publication de la demande: 20.07.2011
(73) Titulaire: Commissariat à l'Énergie Atomique et aux Énergies Alternatives, 75015 Paris (FR)
(72) Inventeur: MAINDRON, Tony, F-38000 Grenoble (FR); PRAT, Christophe, F-44220 Coueron (FR)
(74) Mandataire: Gevers & Orès
(86) Numéro de dépôt international: PCT/FR2009/001124
(87) Numéro de publication internationale: WO 2010/037920

(56) Documents cités:
- EP-A- 1 788 648
- WO-A-01/82389
- WO-A-2008/057045

## Description

La présente invention concerne un procédé d'encapsulation d'un dispositif électronique. L'invention s'applique par exemple à des dispositifs à diodes électroluminescentes organiques (« OLED ») tels que des microafficheurs ou microécrans, à cellules photovoltaïques ou encore à transistors organiques à couches minces (« TFT »), à titre non limitatif.

De manière connue, les dispositifs optoélectroniques organiques, tels que les « OLED », les dispositifs à cellules photovoltaïques et ceux à « TFT » organiques nécessitent d'être encapsulés, pour assurer la protection de leurs composants sensibles contre les espèces gazeuses de l'atmosphère (principalement l'oxygène et la vapeur d'eau). En effet, si cette protection n'est pas convenablement réalisée, il risque de se produire une dégradation ultérieure du dispositif qui se manifeste principalement par l'apparition de points noirs non émissifs dans le cas des « OLED », qui sont en fait la résultante de la pénétration de la vapeur d'eau dans la diode, ce qui dégrade l'interface cathode (ou anode) / film(s) organique(s). Le document WO2008/057045A décrit un procédé d'encapsulation d'un dispositif opto-électronique. Cette encapsulation peut être typiquement réalisée grâce à l'utilisation d'un capot de verre collé sur le dispositif organique à l'aide d'une colle spécifique présentant notamment une faible perméabilité à l'eau. En général, on ajoute un absorbeur d'humidité solide ou « getter » entre le substrat et le capot pour prolonger la durée de vie du dispositif. L'encapsulation par capot est bien adaptée aux dispositifs rigides, mais elle ne l'est pas pour les dispositifs à supports souples (e.g. écrans flexibles). Cette technique encapsulation n'est pas non plus envisageable en cas de manque de place sur le circuit du substrat, par exemple pour un microafficheur sur « CMOS » (semi-conducteur à oxyde de métal complémentaire), et elle est à éviter si l'on souhaite minimiser le poids du dispositif, en particulier dans le cas de grandes surfaces d'émission.

Dans tous ces cas où l'encapsulation par capot ne convient pas, on adopte généralement une encapsulation dite « monolithique », i.e. par des couches minces possédant de bonnes qualités de barrière à l'oxygène et à la vapeur d'eau, notamment. Les matériaux les plus utilisés pour cette application sont en général des oxydes et/ou nitrures diélectriques de formule SiOx, SiNx, SiOxNy, AlxOy déposés usuellement par des techniques de dépôt chimique en phase vapeur (« CVD » pour « Chemical Vapor deposition ») éventuellement assisté par plasma (« PECVD » pour « Plasma Enhanced Chemical Vapor deposition ») ou de dépôt de couche atomique (« ALD » pour « Atomic Layer Déposition »), techniques préférées au dépôt physique en phase vapeur (« PVD » pour Physical Vapor Déposition ») qui, comme la pulvérisation, sont la plupart du temps trop agressives vis-à-vis des semiconducteurs organiques ou bien conduisent à la formation de films aux propriétés insatisfaisantes pour des applications de barrière du fait de nombreux défauts de type trous d'épingles (« pinholes » en anglais) de ces films obtenus par évaporation. En effet, les techniques de « PECVD » et d'« ALD » présentent l'avantage d'être très « conformantes » (i.e. avec un excellent recouvrement de marche ou « step coverage » en anglais) pour les films déposés qui présentent beaucoup moins de défauts que ceux obtenus par les techniques « PVD ».

Les structures d'encapsulation à couche inorganique unique actuellement obtenus par ces techniques « PECVD » ou « ALD » présentent néanmoins des propriétés d'imperméabilité aux gaz de l'atmosphère qui laissent encore à désirer du fait des défauts qui subsistent malgré tout dans ces couches. Par exemple, si l'on décide d'améliorer l'imperméabilité à la vapeur d'eau d'un film de PET commercial de perméabilité voisine de 1 g/m²/jour en déposant à sa surface par « PECVD » à basse température un film inorganique en nitrure de silicium (cas d'un emballage alimentaire), on améliorera au mieux d'un facteur 100 cette imperméabilité et l'empilement PET/SiNₓ aura alors dans le meilleur des cas une perméabilité à la vapeur d'eau d'environ 10⁻² g/m²/jour.

Afin de réduire encore cette perméabilité à la vapeur d'eau, on a cherché récemment à réaliser des empilements multicouches organique/ inorganique/ organique/ inorganique/ ..., comme ceux commercialisés sous la dénomination Barix®, où la couche polymérique inférieure de chaque empilement unitaire organique/ inorganique (cet empilement est appelé « dyad » en anglais) qui est déposée sous vide par évaporation permet de « décorréler » les défauts d'une couche inorganique à une autre afin d'augmenter la sinuosité du trajet pour la vapeur d'eau et de retarder ainsi sa diffusion à travers la structure d'encapsulation. De cette manière, on sait aujourd'hui réduire la perméabilité à la vapeur d'eau d'une telle structure à des valeurs proches de 10⁻⁶g/m²/jour, ce qui procure une durée de vie suffisante pour envisager la commercialisation de dispositifs d'affichage « OLED ».

Une autre grande famille de structures d'encapsulation multicouches est commercialisée par Philips sous la dénomination « NONON », et consiste en un empilement alterné de couches d'un nitrure et d'un oxyde, par exemple de type SiNₓ/ SiOₓ/ SiNₓ/ SiOₓ/....

On peut également citer pour l'encapsulation de dispositifs « OLED » la structure multicouches décrite dans le document US-A-2007/0184292, comprenant un empilement interne organique/ inorganique surmonté d'un empilement externe à deux couches polymériques qui sont reliées entre elles par une couche adhésive dont les deux interfaces avec ces couches polymériques sont formées de deux films réticulés à chaud.

Un inconvénient majeur des structures multicouches à couches organiques et inorganiques alternées, telles que celles de type Barix®, réside dans l'épaisseur relativement élevée (en général supérieure à 500 nm) de chaque couche polymérique intercalée entre deux couches inorganiques, ce qui conduit à une épaisseur totale élevée de la structure constituée de n empilements unitaires organique/ inorganique pour l'obtention des propriétés d'imperméabilité voulues à l'oxygène et à la vapeur d'eau. Ainsi, pour quatre de ces empilements unitaires, on peut facilement dépasser les 2 µm, ce qui n'est pas envisageable pour certains dispositifs tels les microécrans sur un substrat « CMOS » qui requièrent des encapsulations très fines. En effet, la qualité de ces microécrans dépend du rapport d'ouverture entre la surface de chaque pixel émettant la lumière et celle du filtre coloré correspondant, qui est usuellement disposé sur la face interne du capot transparent de protection collé au microécran, lequel rapport est directement lié à la distance séparant les filtres colorés des pixels et donc à l'épaisseur de la structure d'encapsulation et/ou de la colle surmontant le microécran.

Un but de la présente demande est de proposer un dispositif optoélectronique organique, tel qu'un dispositif d'affichage, d'éclairage ou de signalisation par exemple à diodes électroluminescentes organiques (« OLED »), à cellules photovoltaïques ou à transistors organiques à couches minces (« TFT »), ce dispositif étant revêtu d'une structure multicouches d'encapsulation étanche comportant une alternance de couches inorganiques et de couches organiques, qui permette de remédier à ces inconvénients.

A cet effet, un dispositif selon la demande est tel que l'une au moins de ces couches organiques est formée d'un film adhésif réticulé à base d'une colle réticulable par un rayonnement électromagnétique ou par voie thermique (i.e. à une température élevée pour les couches organiques, typiquement entre 80 et 100° C), le ou chaque film adhésif présentant une épaisseur uniformément inférieure à 200 nm qui est obtenue par un passage sous vide du film déposé et non encore réticulé, de sorte que l'épaisseur totale de la structure d'encapsulation soit minimisée.

On notera que, pour un même nombre d'empilements unitaires organique/ inorganique et l'obtention de propriétés de barrière comparables, l'épaisseur de la structure d'encapsulation selon l'invention est ainsi réduite d'une manière significative en comparaison de celle d'une structure de type Barix®, dans laquelle chaque couche organique présente une épaisseur en général supérieure à 500 nm. Il en résulte qu'un dispositif selon la demande peut présenter, en comparaison de ces structures Barix®, une encapsulation suffisamment fine pour son utilisation dans des applications de type microécran sur substrat « CMOS » ou bien, pour une même épaisseur totale donnée de la structure, des propriétés de barrière encore améliorées du fait d'un nombre supérieur d'empilements unitaires.

Avantageusement, ladite structure d'encapsulation peut comprendre au moins trois empilements unitaires comprenant chacun l'une desdites couches inorganiques et l'une desdites couches organiques.

Selon une autre caractéristique de la demande, lesdites couches inorganiques peuvent former dans ladite structure respectivement une couche inorganique interne, au moins une couche inorganique intermédiaire disposée entre deux desdites couches organiques et une couche inorganique externe.

De préférence, chacune desdites couches organiques est formée du film adhésif selon la demande. Dans ce cas préférentiel, chaque empilement unitaire comprend ainsi ladite colle dans sa couche organique, étant précisé que les caractéristiques chimiques et/ou d'épaisseur de chaque film adhésif peuvent varier d'un empilement unitaire à un autre.

Selon une autre caractéristique de la demande ledit ou chaque film adhésif peut présenter une épaisseur qui est inférieure ou égale à 150 nm et qui est avantageusement obtenue par un passage sous vide (au moins primaire) par exemple mis en oeuvre à une pression sensiblement égale à 1 Pa et à la température ambiante (20° C environ). Par « vide primaire » (également appelé « vide grossier »), on entend de manière connue une zone de pression distincte du vide secondaire (ou vide poussé), lequel est usuellement défini comme étant inférieur à 0,1 Pa.

Avantageusement, ledit ou chaque film adhésif peut présenter une épaisseur comprise entre 80 nm et 120 nm, ladite colle étant de préférence une colle réticulable par un rayonnement ultraviolet choisie dans le groupe constitué par les colles acrylate et les colles époxy. A titre encore plus préférentiel, cette colle est une colle époxy monocomposant, par exemple une colle liquide dont la viscosité à l'état non réticulé et dans les conditions normales ambiantes est comprise entre 20 mPa.s et 40 mPa.s (par « conditions normales ambiantes », on entend de manière connue à une température de 20° C, une humidité relative de 65 % et une pression atmosphérique de 101 325 Pa).

Selon une autre caractéristique de l'invention, chacune desdites couches inorganiques est formée d'une couche mince d'épaisseur inférieure à 200 nm, qui est à base d'au moins un composé diélectrique compatible avec celui de chaque couche organique adjacente et qui est obtenue par un dépôt de couche atomique (« ALD »), un dépôt chimique en phase vapeur assisté par plasma ou non (« PECVD » ou « CVD »), ou un dépôt physique en phase vapeur (« PVD »). Ce composé diélectrique est de préférence choisi dans le groupe constitué par les composés de formule SiOₓ, SiNₓ, SiOₓN_{y}, ZnSe, ZnO, Sb₂O₃, les oxydes d'aluminium et les oxydes transparents conducteurs (OTC), notamment les oxydes d'étain-indium.

De préférence, chaque couche inorganique est obtenue par un dépôt « ALD » et peut alors présenter une épaisseur comprise entre 20 nm et 50 nm. Dans ce cas, chaque empilement unitaire peut avantageusement présenter une épaisseur comprise entre 90 nm et 130 nm.

Selon un mode avantageux de réalisation de la demande, ledit dispositif peut comprendre un substrat semi-conducteur revêtu sur l'une au moins de ses faces d'une unité électroluminescente (par exemple à « OLED », étant précisé que tous autres composants électroluminescents pourraient être utilisés) comportant au moins deux électrodes interne et externe entre lesquelles est intercalée une structure émettrice de lumière et dont l'une au moins est transparente à la lumière émise, et ladite structure d'encapsulation recouvre alors ladite électrode externe.

Conformément à ce mode de réalisation de la demande, les empilements unitaires de la structure d'encapsulation recouvrant l'unité électroluminescente sont avantageusement au moins au nombre de quatre, et cette structure peut alors présenter une épaisseur totale sensiblement égale à 500 nm dans le cas où elle comprend cinq de ces empilements unitaires.

Egalement conformément à ce mode de réalisation de la demande, ledit dispositif peut être en outre pourvu d'une plaque de protection collée sous pression sur l'unité électroluminescente surmontée de ladite structure d'encapsulation (cette plaque peut être réalisée en un matériau transparent à la lumière émise par l'unité électroluminescente, comme le verre ou une matière plastique).

Dans le cas particulier d'un dispositif d'affichage comportant un microécran couleur, on notera que cette plaque de protection peut être pourvue de filtres optiques colorés ou de moyens changeurs de couleurs sur sa face d'assemblage, de telle manière que ces filtres ou ces moyens soient disposés en regard des points de couleur correspondants de chacun des pixels du microécran.

Dans ce cas et comme indiqué précédemment en relation avec les microécrans sur substrat « CMOS », l'épaisseur réduite de la structure d'encapsulation de l'invention permet de minimiser la distance totale séparant les pixels du microécran des filtres colorés disposés sur la face interne de la plaque de protection (l'épaisseur de la colle appliquée sous cette plaque étant inchangée), améliorant ainsi la valeur du rapport d'ouverture du microécran.

Un procédé d'encapsulation selon l'invention est décrit dans la revendication 1. Avantageusement, l'on réticule le film adhésif de chaque empilement unitaire avant de réaliser le dépôt ultérieur de l'étape d).

On notera qu'un avantage de ce procédé d'encapsulation en comparaison d'un procédé d'évaporation sous vide de type Barix® réside dans le gain de temps pour réaliser le passage sous vide à l'étape c) selon l'invention, la durée de cette opération n'excédant pas une minute.

Comme indiqué précédemment, la colle utilisée pour chaque couche organique est de préférence réticulée par un rayonnement ultraviolet, s'agissant d'une colle acrylate ou époxy à titre plus préférentiel, l'épaisseur obtenue pour le film adhésif de chaque empilement unitaire étant de préférence comprise entre 80 nm et 120 nm. On notera que plusieurs ou chacun des films adhésifs de la structure selon l'invention pourraient comprendre, outre ladite colle, un ou plusieurs additifs tels qu'un surfactant.

On notera que ce dépôt par « ALD » qui est choisi à titre préférentiel pour l'obtention de chaque couche inorganique de la structure selon l'invention, peut être mis en oeuvre à basse température et permet d'obtenir une couche de densité élevée et de perméabilité très réduite qui épouse au plus près les micro- ou nanoreliefs de la surface concernée.

D'autres avantages, caractéristiques et détails de l'invention ressortiront du complément de description qui va suivre en référence aux dessins annexés, donnés uniquement à titre d'exemples et dans lesquels :
la figure 1 est une vue schématique en coupe transversale illustrant une structure multicouches d'encapsulation selon un exemple de réalisation qui surmonte un dispositif optoélectronique,
la figure 2 est une vue schématique en coupe transversale d'un dispositif optoélectronique de type microécran selon un mode de réalisation qui est apte à recevoir la structure d'encapsulation de la figure 1, et
la figure 3 est une vue schématique en coupe transversale du dispositif optoélectronique de la figure 2, sur lequel a en outre été collée une plaque de protection pourvue de filtres colorés et qui peut également incorporer la structure de la figure 1.

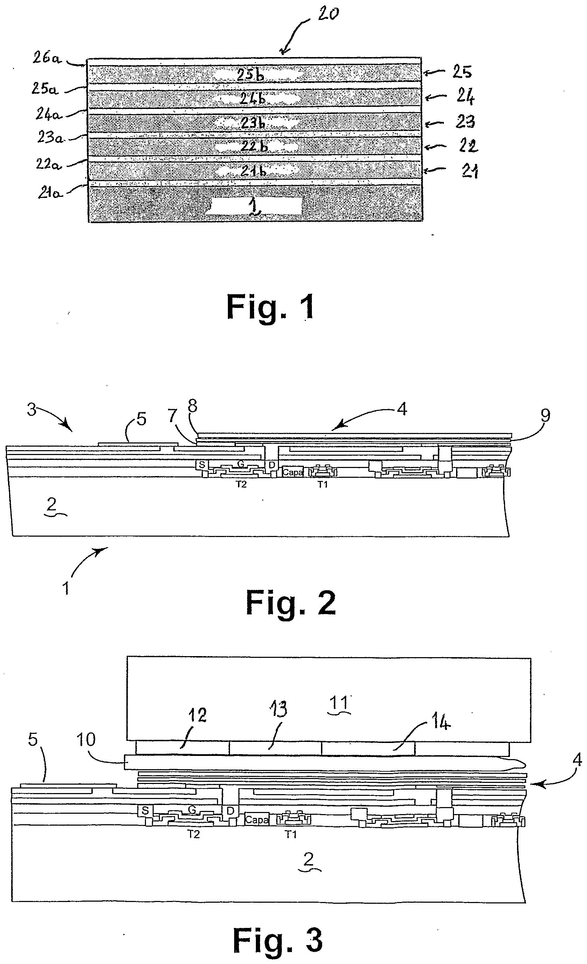

La structure d'encapsulation 20 multicouches illustrée à la figure 1 recouvre la face externe d'un dispositif optoélectronique 1 (e.g. la face d'émission d'un dispositif électroluminescent 1), dont les composants sensibles sont à protéger de l'humidité et de l'oxygène de l'air ambiant. Cette structure d'encapsulation étanche 20 comprend cinq empilements unitaires 21 à 25 chacun constitués d'une couche mince inorganique 21a à 25a revêtue d'une couche organique, laquelle forme un film adhésif réticulé 21b à 25b d'épaisseur réduite et est intercalée entre deux couches inorganiques 21a et 22a, 22a et 23a, 23a et 24a, 24a et 25a, y compris la couche organique la plus externe 25b. En effet, cette dernière est recouverte d'une couche mince inorganique externe 26a qui définit la face extérieure de la structure d'encapsulation 20. Il convient de noter que ces diverses couches de la figure 1 ne sont pas représentées à l'échelle de leurs épaisseurs et longueurs respectives dans le plan de coupe.

Le premier empilement unitaire interne 21 de la structure 20 peut être déposé sur le dispositif 1 selon les étapes successives suivantes :
- on dépose en premier lieu de préférence par la technique « ALD » un composé diélectrique transparent par exemple de formule SiOₓ, SiNₓ, SiOₓN_{y}, ZnSe, ZnO, Sb₂O₃, Al₂O₃ ou In₂O₃/ SnO₂ sur la face externe du dispositif 1 (e.g. sur une électrode externe 9 d'unité électroluminescente, voir figures 2 et 3), pour former une couche inorganique interne 21a d'épaisseur très réduite et avantageusement comprise entre 20 nm et 30 nm,
- on enduit par exemple à la tournette cette couche inorganique interne 21a d'une couche organique adhésive à base d'une colle réticulable par un rayonnement UV, de préférence une colle liquide époxy monocomposant de tension de vapeur élevée (telle que celles commercialisées par la société Epoxy Technology sous la dénominationa générique « OG », la colle « OG 146 » étant préférée et étant optionnellement additionnée d'un surfactant, par exemple non ionique, commercialisé par le groupe 3M sous la dénomination « FC4430 »), la couche organique ainsi obtenue présentant une épaisseur comprise entre 500 nm et 1 µm,
- on soumet cette couche organique à un passage sous vide primaire, mis en oeuvre pendant 60 secondes environ à 20° C et à la pression de 1 Pa, pour réduire son épaisseur à environ 100 nm, le film adhésif 21b à 25 b très aminci qui est ainsi obtenu présentant une épaisseur avantageusement uniforme, puis
- on réticule le film adhésif 21b à 25b ainsi obtenu par un rayonnement UV pendant 40 secondes environ.

Pour l'obtention de chacun des autres empilements unitaires 22 à 25 de la structure d'encapsulation 20, on répète ces opérations en déposant finalement l'ultime couche inorganique externe 26a sur le dernier empilement 25. On obtient ainsi une alternance de n couches organiques et n+1 couches inorganiques (n=5 dans l'exemple de la figure 1, étant entendu que n pourrait prendre des valeurs différentes en fonction des caractéristiques d'imperméabilité souhaitées pour la structure 20, n étant au moins égal à deux).

On notera que ce procédé d'encapsulation selon l'invention est avantageusement mis en oeuvre en un temps réduit en comparaison du procédé d'encapsulation de type Barix® où les couches organiques polymériques sont déposées par évaporation sous vide.

Le dispositif optoélectronique 1 illustré dans l'exemple des figures 2 et 3 est par exemple de type microécran « OLED », comprenant de manière connue un substrat 2 typiquement en silicium revêtu d'une unité électroluminescente 3 définissant une zone active 4 et une zone de connexion électrique 5. L'unité électroluminescente 3 comporte deux électrodes interne 7 et externe 8 entre lesquelles est intercalée une structure émettrice de lumière 9, l'une au moins des électrodes 8 (dans cet exemple l'électrode externe) étant transparente ou semi-transparente à la lumière émise par la structure 9 afin de faire rayonner la lumière émise via la zone active 4 vers l'extérieur du dispositif 1.

L'électrode externe 8 est de préférence constituée d'un métal tel que l'argent, l'aluminium ou le samarium pour les propriétés de transparence de ces métaux dans le domaine visible ainsi que pour leur conductivité électrique à faible épaisseur (l'épaisseur de l'électrode externe 8 est par exemple comprise entre 10 nm et 30 nm). La structure émettrice « OLED » 9 est par exemple constituée d'un empilement de films organiques conçu pour transférer les électrons et les trous qui proviennent des électrodes 7 et 8 et qui sont recombinés pour générer des excitons et donc l'émission de lumière.

Comme illustré à la figure 3, l'unité électroluminescente 3 peut être solidarisée via une colle 10 (de préférence acrylate ou époxy également réticulable par un rayonnement UV), avec une plaque de protection 11 par exemple en verre ou en matière plastique qui est pourvue sur sa face interne de filtres optiques colorés 12, 13, 14 disposés en regard des points de couleur correspondants de chaque pixel du microécran 1. Cette colle 10 est appliquée à l'état non réticulé de manière connue en soi sur la face interne de la plaque 11 et/ou de l'unité électroluminescente 3 surmontée de la structure d'encapsulation 20, puis la plaque 11 est appliquée par pression sur l'interface d'assemblage encollée.

On notera que l'épaisseur réduite de la structure d'encapsulation 20 obtenue, qui est de l'ordre de 500 nm dans l'exemple de la figure 1, permet de minimiser la distance totale entre les pixels et ces filtres colorés 12, 13, 14 (en incluant l'épaisseur de la colle 10) pour l'obtention de propriétés de barrière données, améliorant ainsi la valeur du rapport d'ouverture du microécran couleur 1.

## Revendications

1. Procédé d'encapsulation d'un dispositif optoélectronique organique (1), **caractérisé en ce qu'**il comprend les étapes successives suivantes :
a) on dépose une couche inorganique interne (21a) de moins de 200 nm d'épaisseur sur au moins une face externe de ce dispositif, au moyen d'un dépôt de couche atomique (« ALD »), d'un dépôt chimique en phase vapeur assisté par plasma ou non (« PECVD » ou « CVD »), ou d'un dépôt physique en phase vapeur (« PVD »), ,
b) on enduit cette couche inorganique interne d'une couche organique adhésive à base d'une colle réticulable (10) par un rayonnement électromagnétique ou par voie thermique, la couche organique ainsi obtenue présentant une épaisseur comprise entre 500 nm et 1 µm,
c) on soumet à un passage sous vide la couche organique ainsi obtenue pour la transformer en un film adhésif (21b à 25b) d'épaisseur uniforme inférieure à 200 nm, obtenant ainsi un premier empilement unitaire (21) de deux couches inorganique (21a) et organique (21b),
d) on dépose successivement au moins un autre empilement unitaire (22 à 25) de deux couches inorganique (22a à 25a) et organique (22b à 25b) en mettant de nouveau en oeuvre les étapes a) à c), par le dépôt d'une couche inorganique intermédiaire (22a à 25a) à la place de la couche inorganique interne de l'étape a) et analogue à cette dernière, puis
e) on dépose une ultime couche inorganique externe (26a) analogue à la ou chaque couche inorganique intermédiaire, sur le film adhésif (25b) du dernier empilement unitaire (25),
étant précisé que l'on réticule par ledit rayonnement électromagnétique ou par voie thermique le film adhésif (21b à 25b) de chaque empilement unitaire (21 à 25) séparément, ou bien l'ensemble des films adhésifs suite à l'obtention de ces empilements unitaires.

2. Procédé selon la revendication 1, **caractérisé en ce que** ladite couche inorganique interne est à base d'au moins un composé diélectrique choisi dans le groupe constitué par les composés de formule SiOₓ, SiNₓ, SiOₓN_{y}, ZnSe, ZnO, Sb₂O₃, les oxydes d'aluminium et les oxydes transparents conducteurs (OTC).

3. Procédé selon l'une quelconque des revendication 1 et 2, **caractérisé en ce que** la couche inorganique interne (21a) est déposée lors de l'étape a) sur une électrode externe (8) d'une unité électroluminescente (3).

4. Procédé selon l'une quelconque des revendications 1 à 3, **caractérisé en ce que** la couche inorganique (21a à 26a) présente une épaisseur comprise entre 20 nm et 50 nm et est obtenue par un dépôt de couche atomique ("ALD").

5. Procédé selon l'une quelconque des revendications 1 à 4, **caractérisé en ce que** le passage sous vide est primaire.

6. Procédé selon la revendication 5, **caractérisé en ce que** le passage sous vide primaire est mis en oeuvre pendant 60 secondes environ à 20° C et à une pression sensiblement égale à 1 Pa.

7. Procédé selon l'une quelconque des revendications 1 à 6, **caractérisé en ce que** ladite colle est réticulée par un rayonnement ultraviolet et est choisie dans le groupe constitué par les colles acrylate et époxy.

8. Procédé selon la revendication 7, **caractérisé en ce que** l'épaisseur obtenue pour le film adhésif (21b à 25b) de chaque empilement unitaire (21 à 25) est comprise entre 80 nm et 120 nm.

9. Procédé selon la revendication 8, **caractérisé en ce que** :
- chaque couche inorganique (21a à 26a) présente une épaisseur comprise entre 10 nm et 50 nm et est déposée par un dépôt de couche atomique (« ALD »), et
- chaque empilement unitaire (21 à 25) présente une épaisseur comprise entre 90 nm et 130 nm.

## Patentansprüche

1. Verfahren zum Einkapseln einer organischen optoelektronischen Vorrichtung (1), **dadurch gekennzeichnet, dass** sie die folgenden aufeinanderfolgenden Schritte umfasst:
a) Abscheiden einer anorganischen Innenschicht (21a) von weniger als 200 nm Stärke auf mindestens einer Außenfläche der Vorrichtung mittels einer Atomlagenabscheidung ("ALD"), einer plasmaunterstützten oder nicht plasmaunterstützten chemischen Gasphasenabscheidung ("PECVD" oder "CVD") oder einer physikalischen Gasphasenabscheidung ("PVD"),
b) Auftragen einer organischen Klebeschicht basierend auf einem vernetzbaren Klebstoff (10) auf die anorganische Innenschicht durch eine elektromagnetische Strahlung oder nach dem Wärmeverfahren, wobei die dadurch erhaltene organische Schicht eine Stärke aufweist, die zwischen 500 nm und 1 µm umfasst,
c) Unterziehen der dadurch erhaltenen organischen Schicht eines Vakuumkanals, um sie in einen Klebefilm (21b bis 25b) mit einheitlicher Stärke von weniger als 200 nm umzuwandeln, wodurch ein erster Einzelstapel (21) aus zwei anorganischen (21a) und organischen Schichten (21b) erhalten wird,
d) Platzieren mindestens eines anderen Einzelstapels (22 bis 25) der zwei anorganischen (22a bis 25a) und organischen Schichten (22b bis 25b) nacheinander durch erneutes Durchführen der Schritte a) bis c), durch die Abscheidung einer anorganischen Zwischenschicht (22a bis 25a) anstelle der anorganischen Innenschicht aus Schritt a) und ähnlich der letzteren, dann
e) Abscheiden einer letzten anorganischen Außenschicht (26a) ähnlich der oder jeder anorganischen Zwischenschicht auf dem Klebefilm (25b) des letzten Einzelstapels (25),
wobei angemerkt wird, dass der Klebefilm (21b bis 25b) von jedem Einzelstapel (21 bis 25) einzeln oder die Gesamtheit der Klebefilme nach dem Erhalten der Einzelstapel durch die elektromagnetische Strahlung oder nach dem Wärmeverfahren vernetzt werden.

2. Verfahren nach Anspruch 1, **dadurch gekennzeichnet, dass** die anorganische Innenschicht auf mindestens einer dielektrischen Verbindung basiert, die ausgewählt ist aus der Gruppe bestehend aus den Verbindungen der Formel SiOₓ, SiNₓ, SiOₓN_{y}, ZnSe, ZnO, Sb₂O₃, den Aluminiumoxiden und den transparenten, leitfähigen Oxiden (OTC).

3. Verfahren nach einem der Ansprüche 1 und 2, **dadurch gekennzeichnet, dass** die anorganische Innenschicht (21a) während des Schritts a) auf einer Außenelektrode (8) einer elektrolumineszenten Einheit (3) abgeschieden wird.

4. Verfahren nach einem der Ansprüche 1 bis 3, **dadurch gekennzeichnet, dass** die anorganische Schicht (21a bis 26a) eine Stärke aufweist, die zwischen 20 nm und 50 nm umfasst, und durch eine Atomlagenabscheidung ("ALD") erhalten wird.

5. Verfahren nach einem der Ansprüche 1 bis 4, **dadurch gekennzeichnet, dass** der Vakuumkanal primär ist.

6. Verfahren nach Anspruch 5, **dadurch gekennzeichnet, dass** der primäre Vakuumkanal für 60 Sekunden bei etwa 20 °C und mit einem Druck, der im Wesentlichen gleich wie 1 Pa ist, eingesetzt wird.

7. Verfahren nach einem der Ansprüche 1 bis 6, **dadurch gekennzeichnet, dass** der Klebstoff durch eine UV-Strahlung vernetzt wird und ausgewählt ist aus der Gruppe bestehend aus den Acrylat- und Epoxidklebstoffen.

8. Verfahren nach Anspruch 7, **dadurch gekennzeichnet, dass** die für den Klebefilm (21b bis 25b) von jedem Einzelstapel (21 bis 25) erhaltene Stärke zwischen 80 nm und 120 nm umfasst.

9. Verfahren nach Anspruch 8, **dadurch gekennzeichnet, dass**:
- jede anorganische Schicht (21a bis 26a) eine Stärke aufweist, die zwischen 10 nm und 50 nm umfasst, und durch eine Atomlagenabscheidung ("ALD") abgeschieden wird, und
- jeder Einzelstapel (21 bis 25) eine Stärke aufweist, die zwischen 90 nm und 130 nm umfasst.

## Claims

1. Encapsulation process of an organic optoelectronic device (1) **characterised in that** it includes the following successive steps:
a) an internal inorganic layer (21a) with a thickness of less than 200 nm is deposited on at least one external layer of the device, by atomic layer deposition (ALD), by plasma-enhanced chemical vapour deposition (PECVD), by chemical vapour deposition (CVD) or by physical vapour deposition (PVD),
b) the internal inorganic layer is coated with an organic adhesive layer (10) based on an electromagnetic-radiation-curable or heat-curable adhesive, the organic layer thereby obtained having a thickness ranging from 500 nm to 1 µm,
c) the organic layer thus obtained undergoes a vacuum treatment to transform it into an adhesive film (21b to 25b) with an even thickness of less than 200 nm, thereby providing a first unit stack (21) of two inorganic (21a) and organic (21b) layers,
d) in succession, at least one other unit stack (22 to 25) of two inorganic (22a to 25a) and organic layers (22b to 25b) is deposited, again implementing the steps a) to c), by deposition of an inorganic intermediate layer (22a to 25a) replacing the internal inorganic layer of the step a) and analogous to said inorganic layer, then
e) a final external inorganic layer (26a) analogous to the inorganic intermediate layer is deposited on top of the adhesive film (25b) of the last unit stack,
it being mentioned that the adhesive film (21b to 25b) is cured by said electromagnetic radiation of by thermal means separately for each unit stack, or for all the adhesive films following the creation of said unit stacks.

2. Process according to claim 1, **characterised in that** said internal inorganic layer includes at least one dielectric compound chosen from the group that features the compounds of the formula SiOₓ, SiNₓ, SiOₓN_{y}, ZnSe, ZnO, Sb₂O₃, aluminium oxides and transparent conductive oxides (TCO).

3. Process according to any of the claims 1 and 2, **characterised in that** the internal inorganic layer (21a) is deposited during step a) on an external electrode (8) of an electroluminescent unit (3).

4. Process according to any of the claims 1 to 3, **characterised in that** the inorganic layer (21a to 26a) features a thickness between 20 nm and 50 nm and is achieved by atomic layer deposition (ALD).

5. Process according to any of the claims 1 to 4, **characterised in that** the vacuum processing step is primary.

6. Process according to claim 5, **characterised in that** the primary vacuum processing is implemented for 60 seconds at approximately 20°C and at a pressure roughly equal to 1 Pa.

7. Process according to any of the claims 1 to 6, **characterised in that** the adhesive is cured by ultraviolet radiation and is chosen from the group of acrylate and epoxy adhesives.

8. Process according to claim 7, **characterised in that** the thickness achieved for the adhesive film (21b to 25b) of each unit stack (21 to 25) ranges from 80 nm to 20 nm.

9. Process according to claim 8, **characterised in that**:
- each inorganic layer (21a to 26a) features a thickness ranging from 10 nm to 50 nm and is deposited by atomic layer deposition (ALD) and
- each unit stack (21 to 25) has a thickness ranging from 90 nm to 130 nm.
